# EUROPEAN PATENT SPECIFICATION

(11) **EP 1 804 285 B1**
(45) Date of publication and mention of the grant of the patent: **24.10.2018**
(21) Application number: 05077990.9
(22) Date of filing: 27.12.2005
(51) Int. Cl.: H01L 21/336, H01L 29/78, H01L 21/265, H01L 29/423

(54) **Method for manufacturing a transistor with self-aligned channel**
Verfahren zur Herstellung eines Transistors mit selbstausgerichtetem Kanal
Procédé de fabrication d'un transistor avec canal auto-aligné

(43) Date of publication of application: 04.07.2007
(73) Proprietor: Semiconductor Components Industries, LLC, Phoenix, AZ 85008 (US)
(72) Inventor: Hakim, Hedi, B-9700 Oudenaarde (BE)
(74) Representative: Manitz Finsterwald Patentanwälte PartmbB

(56) References cited:
- EP-A- 0 731 504
- WO-A-02/35600
- US-A- 4 232 439
- US-A- 6 025 237
- US-A1- 2002 055 220

## Description

### Technical field of the invention

The present invention relates to a method for manufacturing transistors comprising an electrode such as a control electrode and a doped functional element self-aligned with the electrode, such as a channel self-aligned with the control electrode as well as transistors made by the method. The method according to the present invention is easy to perform and the transistors obtained by this method have an improved reliability.

### Background of the invention

Smart Power technologies have been developed in order to cope with the requirements of the ever-increasing digital content of mixed analogue/digital ASICs used in e.g. automotive, peripheral and consumer applications. The considered Smart Power technology allows designers to integrate complex digital and precision analog circuitry, embedded microprocessors and high-voltage functionality onto a single IC. The technology is suitable for a variety of applications such as sensor interfaces, transceivers and actuator and motor drivers.

An example of a transistor which can be manufactured using the proposed technology is a vertical double diffused metal oxide semiconductor (VDMOS) transistor. The channel of the VDMOS transistor may be formed of e.g. a p-type channel, also referred to as Pbody.

Up till now, manufacturing of a VDMOS transistor comprising a Pbody module in Smart power technology is based on a double photoresist concept, i.e. the use of a first photoresist (CMOS poly patterning mask) and a second photoresist (Pbody mask) for patterning the Pbody openings, e.g. gate, of the device where the remaining photoresist after patterning of the polysilicon gate is kept and fused. The double photoresist concept results in several manufacturability and reliability problems as the channel does not end up self-aligned with the edge of the gate in case the remaining photoresist after the CMOS poly patterning becomes too thin or completely removed, when a margin of approximately 0.2 to 0.4 µm has to be taken into account between the edge of the poly gate and the edge of the Pbody photoresist mask because of alignment tolerance limitation. Furthermore, the Pbody mask becomes not reworkable in case of lithography issues, meaning that if something goes wrong during the application, i.e. coating or development, of the Pbody mask, it is not possible to remove the top photoresist only and restart the operation, because the bottom photoresist remaining from the CMOS poly patterning will be removed also. There is a risk of partial removal or re-deposition of particles of one of the photoresist layers especially at the edge of the gate leading to local anomalies on the channel edge, e.g. local variation of the channel length.

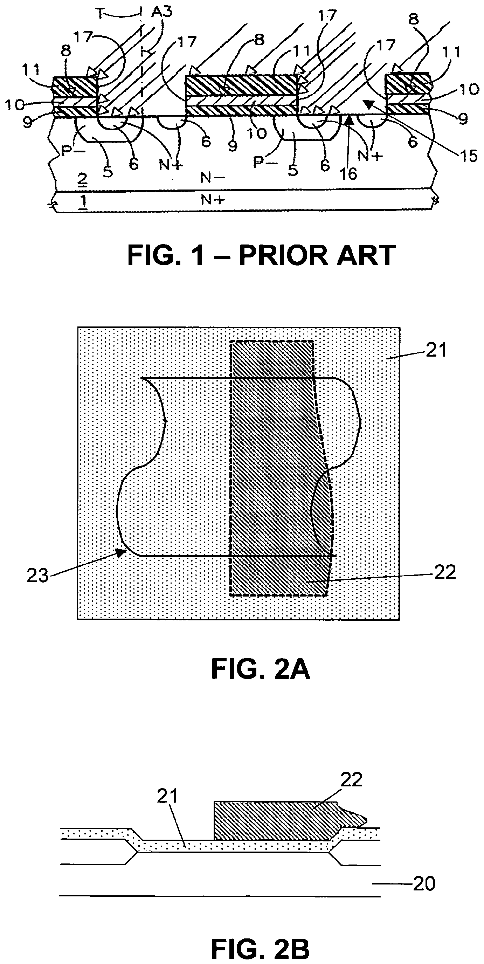

In US 5,670,392 a method for manufacturing high-density MOS-technology power devices is described. The gate of the device is formed by etching windows 15 in an insulated gate layer 8 with an oxide layer 11 on top. According to the process described in US 5,670,392, and partly illustrated in Fig. 1, the implantation mask for the source regions coincides with the implantation mask for the channel regions and for the deep body regions of the elementary functional units. For forming the channel, a P type dopant, such as boron, is selectively implanted into an N- layer 2 formed on an N+ substrate 1 along a direction which lies in a transversal plane, and which is tilted at an angle A3 with respect to the direction T. The tilt angle A3 is chosen, together with the implantation energy, to make the dopant penetrate under edge 17 of the windows 15. In each uncovered surface stripe 16 a P- type stripe 5 is thus formed around an N+ stripe 6 which extends under the insulated gate layer 8 comprising a thermally-grown thin oxide layer 9 and a polysilicon layer 10 to form a channel region of the elementary MOSFETs (see Fig. 1). The above-described steps are repeated by tilting the dopant ion beam at an angle A4 (not shown in the figure), substantially symmetrical to A3, to form in a same manner another P-type stripe 5 along the opposite edge of each window 15.

The method described in US 5,670,392, however, is suitable for being used in discrete technology but is not suitable for being applied to Smart Power technologies where complex digital and precision analog circuitry are integrated in one device. In discrete technologies, only one transistor has to be reproduced on a wafer, meaning that there are no other components on the wafer which might be impacted by particular processing steps. In Smart Power technologies, several types of components are to be integrated on the same die of silicon.

It is also known from EP 0 731 504 to manufacture an integrated circuit comprising lateral DMOS-technology power devices and non-volatile memory cells provides for: forming respective laterally displaced isolated semiconductor regions, electrically insulated from each other and from a common semiconductor substrate, inside which the devices will be formed; forming conductive insulated gate regions for the lateral DMOS-technology power devices. It also shows forming deep body regions aligned with edges of the insulated gate regions, and channel regions extending under the insulated gate regions. The channel regions are formed by means of a second implantation of a second dopant such that said channel regions are formed directly without performing a thermal diffusion at a high temperature.

It is known from WO 02/35600 to produce a DMOS transistor structure in which a protective layer is used to protect the already essentially completed DMOS transistor structure from the negative effects of additional process steps. The DMOS gate electrode is structured using two lithography steps. In a first lithography step, essentially only the source region of the DMOS transistor structure is opened, whereby the electrode layer still present can be used as a mask for the subsequent production of the body region.

It is known from US 6025237 to form field effect transistors include the steps of implanting first conductivity type dopants at a first dose level into a first portion of a relatively lightly doped drift region of first conductivity type semiconductor. A body region of second conductivity type semiconductor is then formed in a second portion of the semiconductor drift region. A gate electrode is then formed on the drift region to extend opposite the body region and the field oxide isolation region. Source and drain regions of first conductivity type semiconductor are then formed in the body region and in a third portion of the drift region spaced from the second portion, respectively, by implanting first conductivity type dopants at a second dose level using the gate electrode and field oxide isolation region as an implant mask.

### Summary of th invention

It is an object of the present invention to provide an improved method for manufacturing transistors. This object is solved by the method recited in claim 1. The invention relates to a method of manufacturing a transistor comprising control electrode and a doped channel self-aligned with the control electrode. An advantage of some embodiments of the present invention is based on providing a manufacturing method for transistors which is compatible with Smart Power technologies and which leads to transistors showing good reliability, preferably improved reliability with respect to prior art transistors.

The overlap is defined by projection of the first mask onto an opening in the second mask or vice versa, according to a direction substantially perpendicular to the plane of the substrate. The final pattern of the control electrode is defined by the first mask with the subtraction of the overlap.

According to embodiments of the present invention, the overlap may be up to 0.4 µm.

In embodiments of the present invention, implanting dopant elements in the substrate is performed under an angle, i.e. in a direction forming an angle α with a direction substantially perpendicular to the plane of the substrate, α being different from zero. The angle α may be between 30° and 60°, and preferably is substantially 45°.

Implanting dopant elements in the substrate is performed using said second mask. Implanting dopant elements is performed after formation of the control electrode, hereby making use of the second mask. A method according to embodiments of the invention may furthermore comprise providing an insulating layer between the substrate and the layer of conductive material.

The control electrode may be a gate.

The transistor may be a DMOS transistor, for example a VDMOS transistor.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 illustrates a doping step in a method for forming a transistor according to the prior art.
Figs. 2A, 2B, 3, 4A, 4B, and 5 to 7 illustrate different steps in a method for manufacturing a transistor with a self-aligned channel according to a first embodiment of the invention.
Fig. 8 to 13 illustrate different steps in a method for manufacturing a transistor with a self-aligned channel not according to an embodiment of the invention, but included for reference.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the claims or technical teaching of the invention, the invention being limited only by the terms of the appended claims.

The embodiments described relates to a method for manufacturing a transistor, especially one comprising a conductive electrode and a transistor internal doped functional component self-aligned with the electrode. An example is a transistor with a control electrode and a channel self-aligned with this control electrode. Preferably, the method according to some embodiments of the present invention may be used to form a double diffused metal-oxide semiconductor (DMOS) transistor such as e.g. a vertical DMOS (VDMOS) transistor.

The method according to this embodiment of the present invention comprises a double etching of a layer of conductive material to form an electrode, e.g. a control electrode, e.g. gate, of a transistor. With double etching of the layer of conductive material is meant that etching of the layer of conductive material comprises two different etching steps. Each etching step is made using a different mask. In other words, a first etching step is performed using a first mask and a second etching step is performed using a second mask. According to this embodiment of the present invention, the first mask and the second mask show a common intersection feature or an overlap. This common intersection feature or overlap is not necessarily a physical common intersection feature or overlap, as both masks do not necessarily touch. The overlap is defined by projection of the first mask onto an opening of the second mask according to a direction substantially perpendicular to the plane of the substrate. A final pattern of the conductive electrode, e.g. of the control electrode, is then defined by the second mask with a subtraction of the overlap. The method furthermore comprises implanting dopant elements to form a channel in a substrate. The method according to the present invention leads to a transistor comprising a control electrode and a self-aligned channel.

According to embodiments of the present invention, implantation of dopant elements in order to form a channel may be performed by means of a tilted implantation. With tilted implantation is meant an implantation in a direction forming an angle α with a direction substantially perpendicular to the plane of the substrate, α being different from zero. The angle α may be between 30° and 60° and may preferably be substantially 45°. With substantially 45° is meant an angle of 45° including a deviation of at most 5%. For a tilt of 30°, a shorter channel is obtained and a deeper Pbody. The shorter the channel, the more it may become critical in terms of leakage current and lateral punch-through. For a tilt of 60°, the channel becomes longer the Pbody shallower, resulting in a higher channel resistance and risk of vertical punch-through. A tilt of 60° may also result in shadowing problems requiring wide Pbody windows. For substantially 45° a maximum dose implanted under the gate is obtained. This is basically the optimum choice in terms of manufacturability and performance.

The method according to embodiments of the present invention comprises in a first step providing a substrate. In embodiments according to the present invention, the term "substrate" may include any underlying material or materials that may be used, or upon which a device, a circuit or an epitaxial layer may be formed. In other alternative embodiments, this "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer.

On top of the substrate an insulating layer may be provided. The insulating layer may be formed of any suitable insulating layer, such as e.g. an oxide layer (e.g. SiO2), a nitride layer (e.g. Si₃N₄). Preferably, the insulating layer may be an oxide layer, most preferably the insulating layer may be a silicon oxide (SiO₂) layer.

In a next step, a layer of conductive material is provided. The layer of conductive material may be formed of any suitable conductive material. For example, the layer of conductive material may be formed of a semiconductor material (e.g. polysilicon), a metal (e.g. gold or aluminium), or may be formed of another material such as an inorganic material e.g. indium tin oxide (ITO). Preferably, the layer of conductive material may be a polysilicon layer.

Next, the layer of conductive material is etched in two steps, each step using a different mask. Thus, a first etching step is performed using a first mask and a second etching step is performed using a second mask. According to the invention, the first and second masks show a common intersection feature or overlap. A final pattern of the conductive material, e.g. control electrode is defined by the first mask with a subtraction of the overlap. The etching of the layer of conductive material in two steps may also be referred to as double etching of the layer of conductive material.

According to embodiments of the invention, implantation of dopant elements may be performed by a tilted implant of dopant elements in the substrate using the second mask. With tilted implant is meant an implant of dopant elements in a direction making a non-zero angle with a direction substantially perpendicular to the plane of the substrate, as described above, preferably an angle between 30 and 60°, more preferred an angle of substantially 45°. With substantially 45° is meant an angle of 45° including a deviation of at most 5%.

Hereinafter an embodiment of the present invention will be described and the materials that may be used to form the different parts of the transistor may be the same as described above, even if the materials are not mentioned explicitly anymore hereinbelow. Furthermore, the following embodiment of the invention will be described by means of a vertical double diffused metal oxide semiconductor (VDMOS) transistor comprising a gate as the control electrode. It is, however, to be understood that this is only for the ease of explanation and that it is not limiting the invention in any way. The invention may also be applied to any other transistor that comprises a control electrode and a self-aligned channel.

In accordance with a first embodiment, a substrate 20 is provided in a first step. In embodiments according to the present invention, the term "substrate" may include any suitable material or layer as described above.

In a next step, which is not illustrated in the figures, an insulating layer may be provided on top of the substrate 20. According to this first embodiment, in which a VDMOS transistor comprising a gate as the control electrode is described, the insulating layer may be a gate insulating layer, preferably a gate oxide layer, which may for example be formed of SiO₂. In the further description the insulating layer will therefore be referred to as gate insulating layer and can be an oxide layer. Again, this is only for the ease of explanation and is not limiting the invention in any way.

On top of the gate insulating layer a layer 21 of a conductive material is deposited. This may be done by means of any suitable technique known by a person skilled in the art, such as, for example, chemical vapour deposition (CVD) or related techniques such as plasma enhanced CVD (PECVD).

Preferably, the layer 21 of conductive material may be formed of polysilicon. However, any other suitable conductive material, such as e.g. a metal, an inorganic conductive material or another semiconductor material, may be used to form the layer 21 of conductive material. In this first embodiment describing a VDMOS transistor the layer 21 of conductive material will further be referred to as a layer 21 of gate material.

According to this first embodiment of the invention, in a next step, a first layer of photoresist material may be deposited on top of the layer 21 of conductive material, in this embodiment on top of the gate material. This may be done by any suitable means, for example, by spincoating or printing. The first layer of photoresist may be made of any suitable polymer that can be used as a photoresist, such as for example poly(vinyl cinnamate) or novolak-based polymers. The first layer of photoresist material may have a thickness of a few µm. For patterning the first layer of photoresist, this layer may be illuminated through a suitable mask e.g. by means of UV light. After illumination, the first layer of photoresist material may be developed by which either the illuminated parts of the photoresist (positive resist) or the non-illuminated parts of the photoresist (negative resist) are removed, depending on which type of photoresist has been used. In that way, the first layer of photoresist material may be patterned to form a first mask 22, in this preferred embodiment a gate mask 22. Alternatively, the first layer of resist material may be patterned by means of an electron beam. Fig. 2A and 2B respectively illustrate a top view and a cross-section of the structure obtained after the formation of the first mask 22, in this first embodiment the gate mask. In Fig. 2A reference number 23 indicates the active region of the device to be formed.

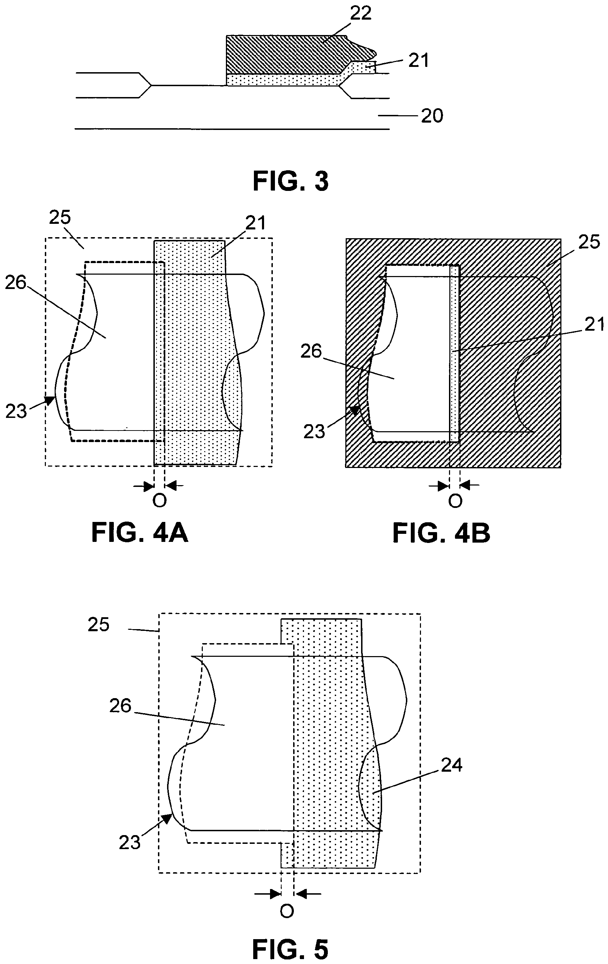

In a next step, exposed parts of the layer 21 of conductive material, in the example given the gate material, or in other words those parts of layer 21 which are not covered by the first mask 22, in this embodiment the gate mask, are removed. This may, for example, be done by dry or wet etching. This step represents a first etching step performed on the layer 21 of conductive material, in this first embodiment the gate material, using the first mask 22, in the example given the gate mask. The result of this first etching step is illustrated in Fig. 3. In a next step, the gate mask 22 may then be removed e.g. by using an organic solvent.

In a further step, a second layer of photoresist material may be applied to the structure so far obtained e.g. by means of spincoating or printing. The second layer of photoresist material may be made of any suitable polymer that can be used as a photoresist, such as for example poly(vinyl cinnamate) or novolak-based polymers. The second layer of photoresist material may then be patterned so as to form a second mask 25, in this first embodiment a body mask 25, and to define a body window 26. Patterning of the second layer of photoresist material may be performed in a similar way as described hereinabove for the first layer of photoresist material. The structure obtained so far is illustrated in Fig. 4A and 4B which both show the result after patterning the second layer of photoresist material, and thus after formation of the second mask 25, in this first embodiment the body mask 25. For simplicity and clarity Fig. 4A only shows the second mask 25 in dashed lines. In Fig. 4B the complete second mask 25 is illustrated.

It can be seen from Fig. 4A and 4B that the second mask 25, in this first embodiment the body mask, shows an overlap O with the patterned layer 21 of conductive material, in the example given gate material. In other words, there is an overlap O or a common intersection feature between an opening of the second mask 25 and the first mask 22 which has been used to pattern the layer 21 of conductive material, in this embodiment the gate material. The overlap O is defined by projection of the first mask 22 onto an opening of the second mask 25 or vice versa, according to a direction substantially perpendicular to the plane of the substrate. The overlap is advantageous for absorbing alignment tolerances in photolithographic processes. The first mask is aligned to a certain reference, in general the active area, with a certain tolerance in the range of 0.1 µm to 0.2 µm for sub-half micrometer Smart Power technologies. The second mask may be aligned to the same reference as the first mask, as well as to the resulting patterns from the first mask itself, with again some tolerance in the same order of magnitude in general. If the second mask is not aligned to the first mask, then the cumulative alignment tolerance has to be taken into account, meaning the range may extend to 0.4 µm if the above-mentioned values are considered.

Because of the overlap O between the opening in the second mask 25, in this embodiment the body mask and the first mask 22, in this embodiment the gate mask, at this stage of the process, there is some conductive material, in this first embodiment gate material, remaining in the opening of the body window 26, as is illustrated in Fig. 4A and 4B. Hence, in a next step, a second etch of the conductive material, in this embodiment gate material, is performed to remove this exposed intersection feature. This results in a final patterning of the layer 21 of conductive material, in this embodiment gate material, and thus in the formation of the control electrode 24, in this embodiment the gate, as illustrated in Fig. 5. The above-described steps result in a self-aligned gate edge and body mask edge. Again, in Fig. 5 for simplicity and clarity, the second mask 25, in this first embodiment body mask, is only shown in dashed lines.

In a further step of the method according to this first embodiment of the invention, an implantation of dopant elements may be performed to form a body layer 27 in the substrate 20. The range of dopant elements used may vary depending on the type of transistor made, e.g. lateral or vertical DMOS, and also on the shape of the elementary cell, e.g. longitudinal stripes or polygonal or circular. In case of LDMOS or VDMOS in stripes, a quad implant with a dose of four times 5E12 to 1E13 cm⁻² may be performed to cover the four possible orientations of the transistor on the wafer, each implant being twisted by 90° by reference to the former implant. The energy used for the implantation may be in the range of e.g. 120 keV to 180 keV for boron. In case of circular and polygonal shapes, the implant might need to be circular or multi-angular.

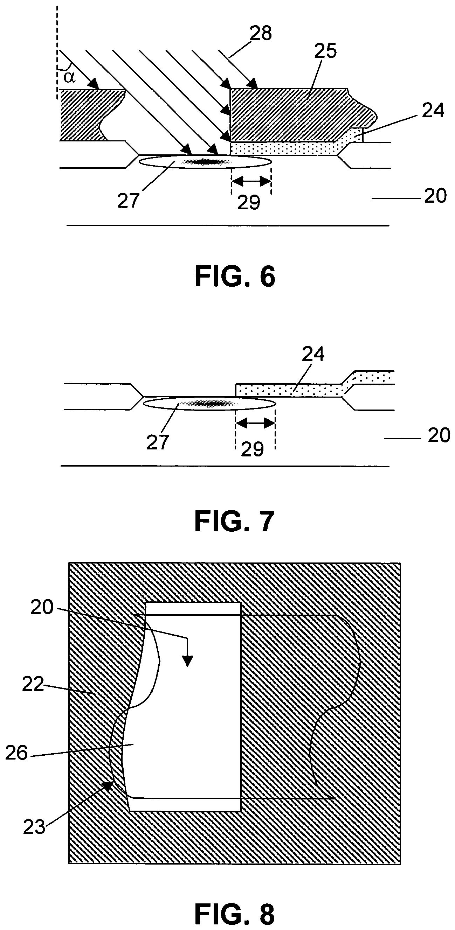

According to this first embodiment, the implantation of dopant elements is performed using the second mask 25, in this embodiment the body mask. The implantation may be performed in a direction, indicated by arrows 28 in Fig. 6, forming an angle α different from zero with a direction substantially perpendicular to the plane of the substrate 20 as illustrated in Fig. 6. Preferably, the angle α may be between 30° and 60°. Preferably the angle α may be substantially 45°, as disclosed above. After this tilted implantation, a body layer 27 and a channel 29 are formed. The channel is self-aligned to an edge of the control electrode 24, in this first embodiment the gate of the VDMOS transistor, as is illustrated in Fig. 6.

In a next step, the second mask 25, in this first embodiment the body mask, may be removed by e.g. stripping. The final result of the transistor, in this preferred embodiment, a VDMOS transistor, after the process according to the first embodiment of the present invention is illustrated in Fig. 7.

The transistor, in the example given the VDMOS transistor, according to the first embodiment of the present invention may further be finished in a conventional way known by a person skilled in the art. For example, contact regions, first and second main electrodes, e.g. source and drain regions and source and drain electrodes, may be formed in any suitable way known by a person skilled in the art.

According to the first embodiment of the invention, the final pattern of the control electrode 24, in the example given the gate, is defined by the first mask 22, in this embodiment the gate mask, however subtracting the common intersection feature or overlap O between the first mask 22 and the opening in the second mask 25. The final pattern of the control electrode 24, e.g. gate, results from the double etching of the control electrode, e.g. gate 24, which is a basic idea of embodiments of the present invention. The method according to the first embodiment of the present invention leads to a transistor, e.g. a VDMOS transistor, with a control electrode 24, in the example given a gate, and a with the control electrode 24 self-aligned channel 29.

In a second method with reference to fig 8 onwards another method of manufacturing a VDMOS transistor will also be described not according to an embodiment of the invention. It has to be understood that this is only for reference, and for the ease of explanation and does not limit the invention in any way.

The method according to this second method may in a first step comprise providing a substrate 20. In embodiments according to the present invention, the term "substrate" may include any suitable material or layer as described above.

On top of the substrate 20 an insulating layer may be provided. For the simplicity of explanation, this step is not illustrated in the figures. According to this method, in which a VDMOS transistor comprising a gate as the control electrode is described, the insulating layer may be a gate insulating layer, e.g. a gate oxide layer, which may preferably be formed of SiO₂. In the further description the insulating layer will be referred to as gate insulating layer. Again, this is only for the ease of explanation and is not limiting the invention in any way.

On top of the gate insulating layer a layer 21 of a conductive material is deposited. This may be done by means of any suitable technique known by a person skilled in the art, such as chemical vapour deposition (CVD) or related techniques such as plasma enhanced CVD (PECVD). Preferably, the layer 21 of conductive material may be formed of polysilicon. However, any other suitable conductive material, such as e.g. a metal, an inorganic conductive material or another semiconductor material, may be used to form the layer 21 of conductive material. In this method, a VDMOS transistor is described comprising a gate. Hence, the layer 21 of conductive material will further be referred to as a layer 21 of gate material.

In a next step, a first layer of photoresist material may be provided on top of the layer 21 of conductive material, in the method given the gate material. This may be done by any suitable technique known by a person skilled in the art, for example by means of spincoating or printing. The first layer of photoresist material may be made of any suitable polymer that can be used as a photoresist, such as for example poly(vinyl cinnamate) or novolak-based polymers. The first layer of photoresist material may have a thickness of a few µm. Thereafter, the first layer of photoresist material may be illuminated through a suitable mask e.g. by means of UV light in order to pattern it. After illumination the photoresist may be developed by which either the illuminated parts of the photoresist (positive resist) or the non-illuminated parts of the photoresist (negative resist) are removed, depending on which type of photoresist has been used. In that way, the first layer of photoresist material may be patterned to form a first mask 22, in this second method a body mask. The first mask 22, in this second method the body
mask, defines an opening or body window 26 through which part of the layer 21 of conductive material, in this second method the gate material, is exposed, as illustrated in Fig. 8.

Next, the layer 21 of conductive material, in this method the gate material, may be etched through the opening or body window 26 in the first mask 22, in this second method the body mask. Fig. 8 illustrates a top view of the device after performing the above described steps, i.e. after patterning of the first mask 22, in this second method the body mask, and after etching of the layer 21 of conductive material, in this second method the gate material. These steps result in self-aligned gate edge and body mask edge.

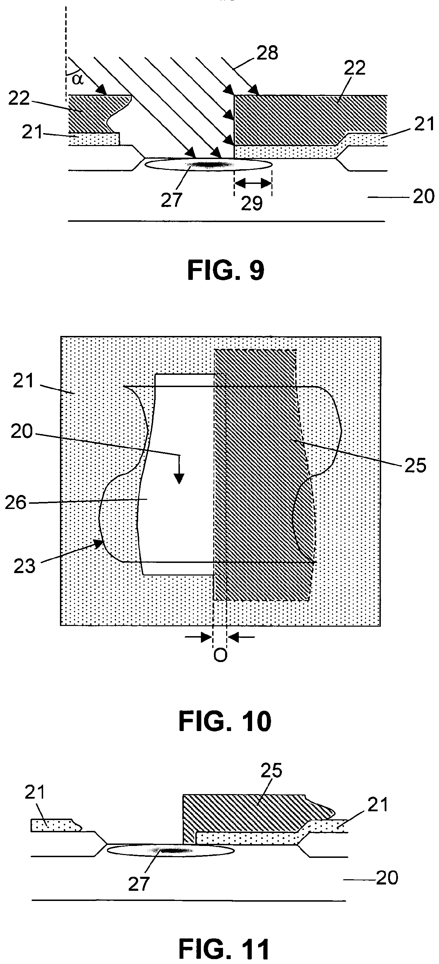

In a next step, implantation of dopant elements may be performed using the first mask 22, in this second method the body mask, and the conductive material underneath. The implantation may be performed in a direction, indicated by arrows 28 in Fig. 9, forming an angle α different from zero with a direction substantially perpendicular to the plane of the substrate 20 as illustrated in Fig. 9. Preferably, the angle α may be between 30° and 60°. Preferably the angle α may be substantially 45°. The above-described steps lead to the creation of a body layer 27.

After the tilted implantation the first mask 22, in this second method the body mask, may be removed by e.g. stripping, and a second layer of photoresist material may be deposited and patterned. The second layer of photoresist material may for example have a thickness of a few µm. The second layer of photoresist material may be patterned in a similar way as already described above in order to form a second mask 25, in this second method a gate mask.

According to this second method, the second layer of photoresist material may be patterned such that the second mask 25, in this method the gate mask, shows an overlap O with the opening in the first mask 22, in this method the body mask (see Fig. 10). Preferably, the overlap O may be such that a sufficient overlap margin is obtained between the resulting second mask 25, in this second method the gate mask, and the control electrode 24, in this second method the gate, in order to protect the edge of the gate 24 of the VDMOS transistor from any influence of next process steps, such as for example an etch step. With sufficient overlap margin is meant that the overlap must be big enough to cope with the alignment tolerance limits as explained above. The overlap is meant to avoid re-etching of the edge of the gate during the second gate etching and after the Pbody implant in order to keep a perfectly self-aligned channel with a constant length. The size of the overlap depends on the alignment tolerance as explained above. The above is illustrated in Fig. 10 and 11 which respectively show a top view and a cross-section of the device formed up till now.

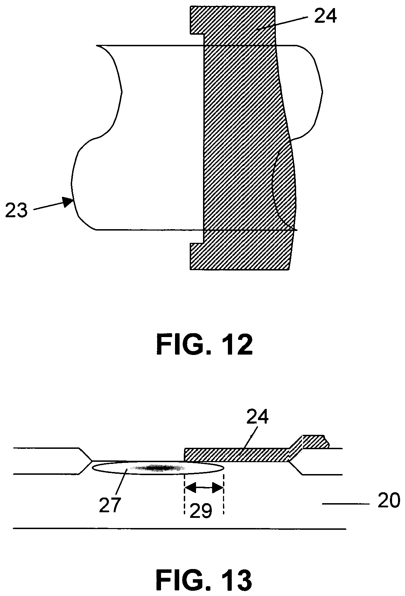

In a further step, the layer 21 of conductive material, in this second method the gate material, may be etched a second time, now using the second mask 25, in this method the gate mask. After this second etch step, the second mask 25 may be removed by, for example, stripping. This results in the final pattern of the control electrode 24, in this second method the gate, of the VDMOS transistor. This is illustrated in Fig. 12 and 13 which respectively show a top view and a cross-section of the transistor, in the example given the VDMOS transistor.

The electronic device, i.e. the VDMOS transistor, according to the preferred embodiment of the present invention may further be finished in a conventional way known by a person skilled in the art. For example, contact regions, first and second main electrodes, e.g. source and drain regions and source and drain electrodes, may be formed in any suitable way known by a person skilled in the art.

According to the second method of the present invention, the final pattern of the control electrode 24, in this embodiment the gate, of the transistor may be defined by the pattern of the second mask 25, however subtracting the intersection feature or overlap. The final pattern of the control electrode 24, e.g. gate, results from the double etching of the control electrode 24, e.g. gate, which is the basic idea of embodiments of the present invention. The method according to the second method leads to a transistor, e.g. a VDMOS transistor, with a control electrode 24, in the example given a gate, and a self-aligned channel 29.

The method according to embodiments of the present invention is useful for any technology with an electrode such as a control electrode and a functional element self-aligned with the electrode, such as a channel self-aligned with the control electrode, and is particularly useful for use in Smart Power technologies. Therefore, the present invention includes a method according to any of the embodiments as described above, used in Smart Power technologies.

It is to be understood that although preferred embodiments, specific constructions and configurations, as well as materials, have been discussed herein for devices according to the present invention, various changes or modifications in form and detail may be made without departing from the scope of the claims of this invention.

## Claims

1. A method for manufacturing a transistor comprising a control electrode (24) and a channel (29) self-aligned to said control electrode, the method comprising:
- providing a substrate (20),
- providing a layer (21) of conductive material on said substrate (20),
- forming, from said layer (21) of conductive material, a control electrode (24) having a final pattern by :
- providing a first mask (22),
- etching the layer (21) of conductive material using said first mask (22), and thereafter
- providing a second mask (25),
wherein the etched layer (21) of conductive material and an opening in said second mask (25) show an overlap (O),
- etching the layer (21) of conductive material using said second mask (25), and thereafter
- implanting dopant elements in the substrate (20) for forming the channel (29) by using said second mask (25),
wherein the final pattern of the control electrode (24) is defined by the first mask (22) with the subtraction of the overlap (O).

2. A method according to claim 1, wherein the overlap (O) between the first mask (22) and the opening in the second mask (25) has an overlap depth of up to 0.4 µm.

3. A method according to claim 1 or 2, the substrate (20) lying in a plane, wherein implanting dopant elements in the substrate (20) is performed in a direction forming an angle α with a direction substantially perpendicular to the plane of the substrate (20), α being different from zero.

4. A method according to claim 3, wherein the angle α is between 30° and 60°.

5. A method according to claim 4, wherein the angle α is 45°.

6. A method according to any of the previous claims, furthermore comprising providing an insulating layer between the substrate (20) and the layer (21) of conductive material.

7. A method according to any of the previous claims, wherein the control electrode (24) is a gate.

8. A method according to claim any of the previous claims, wherein the transistor is a DMOS transistor.

9. A method according to claim 8, wherein the DMOS transistor is a VDMOS transistor.

## Patentansprüche

1. Verfahren zum Herstellen eines Transistors, der eine Steuerungselektrode (24) und einen Kanal (29), der sich selbst auf die Steuerungselektrode ausgerichtet hat, umfasst, wobei das Verfahren umfasst, dass:
- ein Substrat (20) bereitgestellt wird,
- eine Schicht (21) aus leitfähigem Material auf dem Substrat (20) bereitgestellt wird,
- aus der Schicht (21) aus leitfähigem Material eine Steuerungselektrode (24) mit einem endgültigen Muster ausgebildet wird, indem:
- eine erste Maske (22) bereitgestellt wird,
- die Schicht (21) aus leitfähigem Material unter Verwendung der ersten Maske (22) geätzt wird, und anschließend
- eine zweite Maske (25) bereitgestellt wird,
wobei die geätzte Schicht (21) aus leitfähigem Material und eine Öffnung in der zweiten Maske (25) eine Überschneidung (O) aufweisen,
- die Schicht (21) aus leitfähigem Material unter Verwendung der zweiten Maske (25) geätzt wird, und anschließend
- Dotierungselemente in das Substrat (20) implantiert werden, um den Kanal (29) unter Verwendung der zweiten Maske (25) auszubilden,
wobei
das endgültige Muster der Steuerungselektrode (24) durch die erste Maske (22) samt Subtraktion der Überschneidung (O) definiert wird.

2. Verfahren nach Anspruch 1, wobei die Überschneidung (O) zwischen der ersten Maske (22) und der Öffnung in der zweiten Maske (25) eine Überschneidungstiefe von bis zu 0,4 µm aufweist.

3. Verfahren nach Anspruch 1 oder 2, wobei das Substrat (20) in einer Ebene liegt, wobei das Implantieren von Dotierungselementen in das Substrat (20) in eine Richtung ausgeführt wird, die mit einer Richtung im Wesentlichen rechtwinklig zu der Ebene des Substrats (20) einen Winkel α bildet, wobei α von null verschieden ist.

4. Verfahren nach Anspruch 3, wobei der Winkel α zwischen 30° und 60° liegt.

5. Verfahren nach Anspruch 4, wobei der Winkel α 45° beträgt.

6. Verfahren nach einem der vorstehenden Ansprüche, das darüber hinaus umfasst, dass eine Isolationsschicht zwischen dem Substrat (20) und der Schicht (21) aus leitfähigem Material bereitgestellt wird.

7. Verfahren nach einem der vorstehenden Ansprüche, wobei die Steuerungselektrode (24) ein Gate ist.

8. Verfahren nach einem der vorstehenden Ansprüche, wobei der Transistor ein DMOS-Transistor ist.

9. Verfahren nach Anspruch 8, wobei der DMOS-Transistor ein VDMOS-Transistor ist.

## Revendications

1. Procédé pour fabriquer un transistor comprenant une électrode de commande (24) et un canal (29) auto-aligné avec ladite électrode de commande,
le procédé comprenant les étapes consistant à :
- fournir un substrat (20),
- fournir une couche (21) de matériau conducteur sur ledit substrat (20),
- former, à partir de ladite couche (21) de matériau conducteur, une électrode de commande (24) ayant un motif final :
- en fournissant un premier masque (22),
- en attaquant la couche (21) de matériau conducteur en utilisant ledit premier masque (22), et ensuite
- en fournissant un second masque (25),
dans lequel la couche attaquée (21) du matériau conducteur et une ouverture dans ledit second masque (25) présentent un chevauchement (O),
- en attaquant la couche (21) de matériau conducteur en utilisant ledit second masque (25), et ensuite
- en implantant des éléments dopants dans le substrat (20) pour former le canal (29) en utilisant ledit second masque (25),
dans lequel
le motif final de l'électrode de commande (24) est défini par le premier masque (22) avec soustraction du chevauchement (O).

2. Procédé selon la revendication 1, dans lequel le chevauchement (O) entre le premier masque (22) et l'ouverture dans le second masque (25) a une profondeur de chevauchement allant jusqu'à 0,4 µm.

3. Procédé selon la revendication 1 ou 2, le substrat (20) étant situé dans un plan, dans lequel l'implantation d'éléments dopants dans le substrat (20) est effectuée dans une direction formant un angle α avec une direction sensiblement perpendiculaire au plan du substrat (20), α étant différent de zéro.

4. Procédé selon la revendication 3, dans lequel l'angle α est entre 30° et 60°.

5. Procédé selon la revendication 4, dans lequel l'angle α est de 45°.

6. Procédé selon l'une quelconque des revendications précédentes, comprenant en outre l'étape consistant à prévoir une couche d'isolation entre le substrat (20) et la couche (21) de matériau conducteur.

7. Procédé selon l'une quelconque des revendications précédentes, dans lequel l'électrode de commande (24) est une grille.

8. Procédé selon l'une quelconque des revendications précédentes, dans lequel le transistor est un transistor DMOS.

9. Procédé selon la revendication 8, dans lequel le transistor DMOS est un transistor VDMOS.
